## Europäisches Patentamt

## European Patent Office

## Office européen des brevets

(19)

(11) Veröffentlichungsnummer: **0 089 452**
**B1**

(12) **EUROPÄISCHE PATENTSCHRIFT**

(45) Veröffentlichungstag der Patentschrift:
09.04.86

(51) Int. Cl.⁴: **H 04 R 25/02, H 05 K 3/36**

(21) Anmeldenummer: 83100082.3

(22) Anmeldetag: 07.01.83

(54) **Hörgerät mit einer Verstärkerschaltung.**

(30) Priorität: 18.03.82 DE 3209914

(43) Veröffentlichungstag der Anmeldung:
28.09.83 Patentblatt 83/39

(45) Bekanntmachung des Hinweises auf die Patenterteilung:
09.04.86 Patentblatt 86/15

(84) Benannte Vertragsstaaten:
AT CH DE LI NL

(56) Entgegenhaltungen:
EP - A - 0 027 496
DE - B - 1 054 515
FR - A - 2 442 570
GB - A - 1 111 887

(73) Patentinhaber: ROBERT BOSCH GMBH, Postfach 50,
D-7000 Stuttgart 1 (DE)

(72) Erfinder: Jerichow, Bernd, Ing. grad., Ribeckweg 14,
D-1000 Berlin 37 (DE)
Erfinder: Montag, Jürgen, Silbersteinstrasse 91,
D-1000 Berlin 44 (DE)
Erfinder: Müller, Manfred, Ing. grad.,
Säntisstrasse 142 a, D-1000 Berlin 48 (DE)

(74) Vertreter: Schmidt, Hans-Ekhardt, Robert Bosch GmbH
Geschäftsbereich Elektronik Patent- und
Lizenzabteilung Forckenbeckstrasse 9-13,
D-1000 Berlin 33 (DE)

LIBER, STOCKHOLM 1986

## Beschreibung

Die Erfindung geht von einem Hörgerät nach der Gattung des Hauptanspruchs aus.

Es ist schon ein hinter dem Ohr zu tragendes Hörgerät bekannt (Hearing Aid Journal, Oktober 1980, Seite 14), bei dem auf einer in dem Hörgerät angeordneten chassisartigen Leiterplatte mehere senkrecht dazu stehende Dickschichtschaltungen angeordnet sind, deren stiftförmige Kontakte in entsprechende Buchsen der Leiterplatte eingesteckt sind, die mit Leitungsbahnen der Leiterplatte verbunden sind. Buchsen und Steckerstifte sind verhältnismäßig teuer, und ein gegebenenfalls unmittelbares Einlöten der Dickschichtschaltungen in eine Leiterplatte würde im Reparaturfall das Auswechseln der Schaltung erschweren. Außerdem setzt diese Schaltungsart ein kompliziertes Herstellungsverfahren voraus.

Es ist weiterhin bekannt (EP-A-0027496), daß ein Hörgerät eine Hauptleiterplatte enthält, auf die Leiterplatten-Baueinheiten steckbar sind. Je nach den gewünschten Eigenschaften des Hörgerätes wird aus einer Reihe von verschiedenen Leiterplatten-Baueinheiten eine bestimmte Kombination zusammengestellt. Das vorstehend erläuterte Hörgeräte-Konzept hat sich für Taschenhörgeräte bewährt, ist aber technologisch sehr aufwendig und zum Beispiel für hinter dem Ohr zu tragende Hörgeräte aus Platzgründen kaum anwendbar.

Schließlich ist es auch bekannt (FR-A-24 42 570), bei einer gedruckten Schaltung Leitungskreuzungen vorzusehen, die anstelle einer einfachen Drahtbrücke, welche eine Leitungsbahn einer eineitig oder beidseitig kaschierten ersten Leiterplatte überbrücken soll, eine zweite senkrecht auf der ersten Platte befestigte Leiterplatte mit einer gedruckten Leitungsbahn vorgesehen ist. Sollen mehrere leitungsbahnen der ersten Leiterplatte überbrückt werden, so kann eine einzige Leiterplatte mehrere durch Leiterbahnen realisierte Brücken aufweisen. Die zweite Leiterplatte kann darüber hinaus auch als Träger für elektrische Bauelemente dienen. Bei der bekannten gedruckten Schaltung kann die zweite Leiterplatte an der Verbindungsstelle zu der ersten Leiterplatte Nasen tragen, die jedoch lediglich den Zweck haben, daß zwischen zwei benachbarten Nasen eine zu überbrückende Leitungsbahn der ersten Leiterplatte Platz findet.

## Vorteile der Erfindung

Das erfindungsgemäße Hörgerät mit den kennzeichnenden Merkmalen des Patentanspruchs hat den Vorteil, daß als Träger für die Verstärkerschaltung einfache, beidseitig kaschierte Leiterplatten verwendet werden können und daß durch die zungenförmigen, je ein Anschlußelement tragenden Vorsprünge, die in je eine Öffnung der Chassis-Leiterplatte passen, eine besonders einfache Verbindung zwischen der Chassis-Leiterplatte und den Träger-Leiterplatten erreicht wird. Die Träger-Leiterplatten sind vorzugsweise mit bei Dünn- und Dickschichtschaltungen üblichen elektrischen Bauelementen bestückt. Anstelle der bei Dünn- und Dickschichtschaltungen auf einem Substrat aufgebrachten Widerstandsschichten werden bei dem erfindungsgemäßen Hörgerät vorzugsweise diskrete Chip-Widerstände verwendet. Das Auslöten der Träger-Leiterplatten aus der Chassis-Leiterplatte bereitet dem Fachmann keine Schwierigkeiten.

## Zeichnung

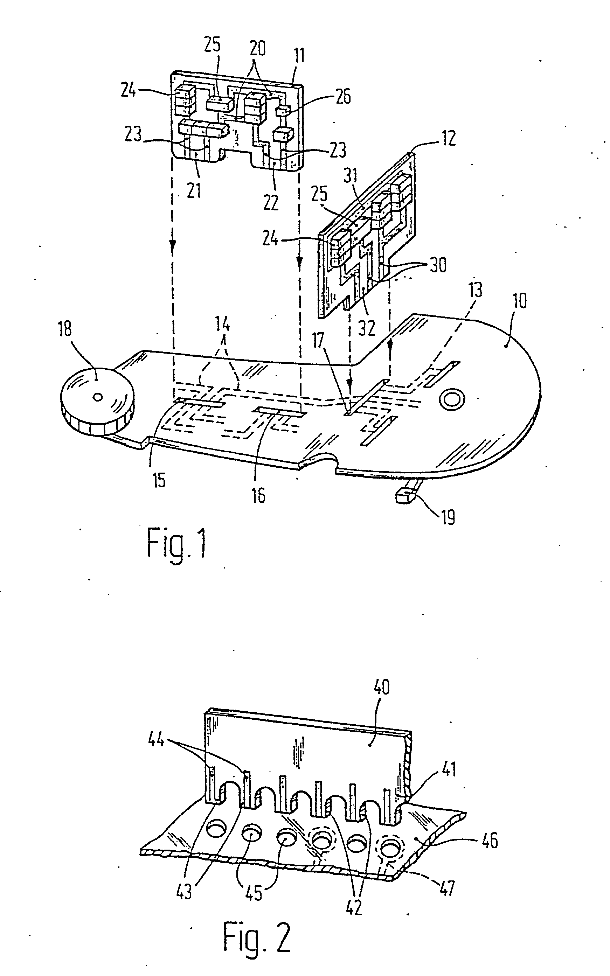

In der Zeichnung stellt Fig. 1 in Verbindung mit Fig. 2 die Erfindung dar, die in der nachfolgenden Beschreibung näher erläutert ist. Die Zeichnung zeigt in

Fig. 1 eine auseinandergezogene, vergrößerte perspektivische Ansicht einer Chassis-Leiterplatte und zweier Träger-Leiterplatten und

Fig. 2 eine vergrößerte perspektivische Ansicht einer erfindungsgemäßen Chassis- und Träger-Leiterplatte.

## Beschreibung der Erfindung

In Fig. 1 sind eine Chassis-Leiterplatte 10 und zwei Träger-Leiterplatten 11, 12 in auseinandergezogener Darstellungsweise gezeigt. Die der Außenform eines hinter dem Ohr zu tragenden Hörgerätes in etwa angepaßte Chassis-Leiterplatte 10 ist auf einer Seite oder auf beiden Seiten mit Leiterbahnen 13 und 14 versehen und enthält schlitzartige Öffnungen 15, 16 und 17. Weiterhin dient die Chassis-Leiterplatte 10 als Träger für einen Einstellwiderstand, von dem in Fig. 1 nur das Einstellrädchen 18 zu sehen ist, und für einen Schalter, dessen Schalthebel mit 19 bezeichnet ist.

Die Träger-Leiterplatte 11 ist etwa U-förmig ausgebildet und trägt beidseitig Leiterbahnen 20. Die freien Enden der U-förmigen Träger-Leiterplatte 11 bilden Zungen 21 und 22, die in Öffnungen 15 und 16 der Chassis-Leiterplatte 10 passen. Im eingesteckten Zustand werden die als Anschlußelemente 23 dienenden freien Enden der Leiterbahnen mit den Leiterbahnen 14 der Chassis-Leiterplatte 10 elektrisch, zum Beispiel durch Lötung, verbunden. Die auf der Träger-Leiterplatte 11 anzuordnenden elektrischen Bauelemente 24, 25, 26 sind diskrete elektrische Bauelemente, wie Kondensatoren, Widerstände und Transistoren, deren Anschlüsse mit entsprechenden Leitungsbahnen 20 durch Lötung verbunden sind.

In analoger Weise ist auch die Träger-Leiterplatte 12 aufgebaut, deren als Anschlußelemente 30 dienenden Enden von Leitungsbahnen 31 auf einem Vorsprung 32 der Träger-Leiterplatte 12 angeordnet sind. Der vorsprung 32 paßt in die schlitzförmige Öffnung 17 der Träger-Leiterplatte 10.

# 0 080 975

Die Erfindung betrifft neue lichtempfindliche Polymere, ein Verfahren zu deren Herstellung, dabei einsetzbare neue Anthrachinonderivate sowie die Verwendung der neuen lichtempfindlichen Polymeren, vor allem +30

Elektrisch leitende Ueberzüge und Muster, vor allem für gedruckte Schaltungen, können unter anderem dadurch hergestellt werden, dass man auf nicht-leitenden anorganischen oder organischen Substraten Fü die stromlose Metallabscheidung geeignete nullwertige Metallkeime erzeugt. Nach dem sogenannten Photoformation-Verfahren kann dies dadurch erfolgen, dass man auf das Substrat, gegebenenfalls in saurem Medium und in Gegenwart von Halogenidionen, Metallsalze, besonders Salze nicht-edler Metalle, wie Kupferformiat, abscjeodet und anschliessend durch Bestrahlung, gegebenenfalls in Gegenwart chemischer Reduktionsmittel, zu nullwertigen Metallkeimen reduziert. Für die Reduktion der Metallsalze werden im allgemeinen lichtempfindliche Reduktionsmittel, ein zweites Reduktionsmittel und ein oberflächenaktives Mittel eingesetzt. Als lichtempfindliche Reduktionsmittel können u.a. Anthrachinondisulfonsäuren und Salze davon, gegebenenfalls im Gemisch mit Metallaktivatoren, wie Zinnsalzen, eingesetzt werden. Dabei müssen die Substrate im allgemeinen vor der Metallabscheidung angeätzt oder mit einer ätzbaren Haftvermittlerschicht versehen werden [intramolekulare photoreduktive Methode; vgl. z.B. US Patentschriften 3.959.547 und 3.993.802].

Gemäss einem weiteren vorbekannten Verfahren wird auf dem nichtleitenden Substrat eine Titandioxid enthaltende lichtempfindliche Schicht erzeugt oder Titandioxid wird in das Substrat eingearbeitet. Anschliessend muss das das Titandioxid enthaltende Substrat bzw. die das Titandioxid enthaltende Schicht angeätzt werden, um die $TiO_2$-Teil-chen für die weitere Behandlung zugänglich zu machen. Das angeätzte Material wird dann mit einer Lösung des gewünschten Metallsalzes behandelt und bestrahlt (photoelektronen-Methode). Schliesslich können nullwertige Metallkeime auch dadurch erhalten werden, dass man auf dem nichtleitenden Substrat zuerst ein lichtempfindliches Metallsalz, wie Zinn(II)hydroxid oder Eisenoxalat, abscheidet, durch Bestrahlung ein latentes Bild bzw. reduzierende Metallionen erzeugt und darauf durch Reduktion eines Metallsalzes, im allgemeinen eines Edelmetallsalzes, die nullwertigen Metallkeime erzeugt (photoelektrochemische Methode). Die so erhaltenen nullwertigen Metallkeime können anschliessend in an sich bekannter Weise durch stromlose Metallabscheidung metallisiert und die leitenden Bildstellen gegebenenfalls durch elektrolytische Metallabscheidung weiter verstärkt werden.

Es wurden nun neue lichtempfindliche polymere gefunden, mit denen Abbildungen, besonders elektrisch leitende Ueberzüge und Muster, auf wesentlich einfachere und wirtschaftlichere Weise hergestellt werden können, wobei auf das Anätzen des Substrats oder die Verwendung von ätzbaren Haftvermittlerschichten verzichtet werden kann. Mit den neuen Polymeren erzeugte Abbildungen zeichnen sich zudem durch ein erhöhtes Auflösungsvermögen aus.

Gegenstand der Erfindung sind somit neue Polymere mit einer Grenzviskosität [η] von mindestens 0,10 dl/g, gemessen bei 25°C N,N-Dimethylformamid, die aus 1 bis 40 Mol% wiederkehrenden 8truktur-elementen der Formel I

FIG01/90mm

und 60 bis 99 Mol.% wiederkehrenden Strukturelementen der Formel II

Während die Träger-Leiterplatte 11 vorzugsweise die Bauelemente eines Vorverstärkers oder einer Regeleinheit trägt, weist die Träger-Leiterplatte 12 die elektrischen Bauelemente für den Endverstärker der Verstärkerschaltung auf.

In Fig. 2 weist eine Träger-Leiterplatte 40 in ihrem Randbereich 41 in gleichmäßigen Abständen Einschnitte 42 auf, durch die zungenförmige Vorsprünge 43 mit je einem Anschlußelement 44 entstehen. Die Vorsprünge passen in vorzugsweise durchkontaktierte Öffnungen 45 einer Chassis-Leiterplatte 46, die der Chassis-Leiterplatte 10 in Fig. 1 ähnelt. Ist die Träger-Leiterplatte 40 mit ihren Zungen 44 in die Öffnungen 45 der Chassis-Leiterplatte 46 gesteckt, so können durch Tauchlötung die Anschlußelemente 44 mit Leiterbahnen 47 an der Unterseite der Chassis-Leiterplatte verbunden werden.

**Patentanspruch**

Hörgerät mit einer Verstärkerschaltung, deren diskrete Bauelemente (24, 25) mindestens teilweise auf Träger-Leiterplatten (11, 40) angeordnet und mit Leiterbahnen dieser Platten verbunden sind, und mit einer Chassis-Leiterplatte (46), auf die die Träger-Leiterplatten gesteckt sind, die mechanisch und elektrisch mit der Chassis-Leiterplatte verbunden sind, dadurch gekennzeichnet, daß die Träger-Leiterplatten an einem Randbereich (41) zungenförmige Vorsprünge (43) mit je einem elektrischen Anschlußelement (44) aufweisen, daß je eine Leiterbahn (40) der beidseitig mit Leiterbahnen versehenen Träger-Leiterplatte in je eines der Anschlußelemente übergeht, daß die Vorsprünge in entsprechende Öffnungen (45) der Chassis-Leiterplatte (46) passen und die Anschlußelemente mit je einer Leiterbahn der Chassis-Leiterplatte verbunden sind, daß als Träger für die Bauelemente eines Vorverstärkers, einer Regeleinheit und eines Endverstärkers je eine Träger-Leiterplatte vorgesehen ist und daß die Chassis-Leiterplatte gleichzeitig Träger für weitere Bauelemente des Hörgerätes, wie zum Beispiel einen Schalter (19), einen Einstellwiderstand (18) und dergleichen ist.

**Claim**

A hearing aid with an amplifier circuit whose discrete components (24, 25) are at least in part disposed on carrier printed circuit boards (11, 40), and connected to tracks on these boards, and with a chassis printed circuit board (46) into which the carrier printed circuit boards are fitted, which are connected mechanically and electrically to the chassis printed circuit boards, characterised in that an edge region (41) of the carrier printed circuit boards is provided with tongue-shaped projections (43) each having an electrical connection element (44), that each of the tracks (40) of the carrier printed circuit board provided on both sides with tracks joins up with one of the connection elements, that the projections fit into corresponding holes (45) in the chassis printed circuit boards (46) and the connection elements are each connected to a track on the chassis printed circuit board, that one carrier printed circuit board each is provided as a carrier for the components of a preamplifier, a control unit and a final amplifier, and that the chassis printed circuit board is simultaneously a carrier for further components of the hearing aid, such as, for example, a switch (19), an adjustable resistor (18), and such like.

**Revendication**

Appareil de correction auditive avec un circuit amplificateur dont les composants discrets (24, 25) sont disposés au moins en partie sur des plaques de circuit imprimé porteuses (11, 40) et sont reliés à des pistes conductrices de ces plaques, cet appareil comportant une plaque de circuit imprimé (46) servant de châssis sur laquelle sont enfichées les plaques de circuit imprimé porteuses qui sont reliées mécaniquement et électriquement avec la plaque de circuit imprimé servant de châssis, appareil caractérisé en ce que les plaques de circuit imprimé proteuses comportent sur une zone de bordure (41) des saillies (43) en forme de languettes comportant chacune un élément de raccordement électrique (44), chacune des pistes conductrices (40) des plaques de circuit imprimé porteuses munies de pistes conductrices des deux côtés se transformant en l'un des éléments de raccordement, les saillies s'adaptant dans des orifices appropriés (45) de la plaque de circuit imprimé (46) servant de châssis et les éléments de raccordement étant chacun reliés à une piste conductrice de la plaque de circuit imprimé servant de châssis, une plaque de circuit imprimé porteuse étant chaque fois prévue pour porter les composants d'un pré-amplificateur, d'une unité de réglage, et d'un amplificateur terminal, tandis que la plaque de circuit imprimé servant de châssis est en même temps porteuse pour d'autres composants de l'appareil de correction auditive comme par exemple un commutateur (19), une résistance de réglage (18), etc..

Fig. 1

Fig. 2